(19) Europäisches Patentamt / European Patent Office / Office européen des brevets

(11) **EP 1 587 214 B1**

(12) **EUROPÄISCHE PATENTSCHRIFT**

(45) Veröffentlichungstag und Bekanntmachung des Hinweises auf die Patenterteilung:
**24.06.2015 Patentblatt 2015/26**

(51) Int Cl.:
*H03K 5/156* (2006.01)     *H03K 5/08* (2006.01)

(21) Anmeldenummer: **05090091.9**

(22) Anmeldetag: **06.04.2005**

(54) **Schaltungsanordnung zur Regelung eines Parameters eines elektrischen Signals**

Circuit for controlling a parameter of an electrical signal

Circuit pour commander un paramètre d'un signal électrique

(84) Benannte Vertragsstaaten:
**DE**

(30) Priorität: **08.04.2004 US 561174 P**
**22.07.2004 US 897179**

(43) Veröffentlichungstag der Anmeldung:
**19.10.2005 Patentblatt 2005/42**

(73) Patentinhaber: **Avago Technologies General IP (Singapore) Pte. Ltd.**
**Singapore 768923 (SG)**

(72) Erfinder:
• **Doppke, Harald**
**45481 Mühlheim/Ruhr (DE)**
• **Harms, Torsten**
**01465 Langebrück (DE)**
• **Theil, Detlev**
**11338 Stockholm (SE)**
• **von Waasen, Stefan**
**19248 Sollentuna (SE)**

(74) Vertreter: **Dilg, Andreas et al**
**Dilg, Haeusler, Schindelmann**
**Patentanwaltsgesellschaft mbH**
**Leonrodstrasse 58**
**80636 München (DE)**

(56) Entgegenhaltungen:
JP-A- 59 008 112     US-A- 4 739 197
US-A1- 2002 005 712     US-A1- 2003 112 044
US-A1- 2003 206 059     US-B1- 6 169 434
US-B1- 6 169 765     US-B1- 6 504 409

**Beschreibung**

Die Erfindung betrifft eine Schaltungsanordnung zur Regelung eines Parameters eines elektrischen Signals. Insbesondere betrifft die Erfindung eine Schaltungsanordnung zur Regelung des Duty Cycle eines elektrischen Signals. Sie findet bevorzugt bei der Regelung des Duty Cycle von dynamischen Schnittstellensignalen in digitalen Kommunikationssystemen Anwendung.

Hintergrund der Erfindung

Unter einem "Duty Cycle" wird in digitalen Kommunikationssystemen das Puls-/Pause bzw. An-/Aus-Verhältnis in einem elektrischen Signal bezeichnet. Insbesondere gibt der Duty Cycle an, zu welchem Prozentsatz ein High-Pegel in einem Signal vorhanden ist. Idealerweise liegt der Duty Cycle bei 50 Prozent bzw. 0,5.

Der Duty Cycle stellt eine wichtige Kenngröße dynamischer Schnittstellensignale in digitalen Kommunikationssystemen dar. Dynamische Schnittstellensignale sind insbesondere Ein-und Ausgangssignale digitaler Kommunikationskomponenten. Für den Duty Cycle gibt es im Allgemeinen sehr restriktive Spezifikationen, um die Funktion einzelner Komponenten in einem Gesamtsystem sicherzustellen. Je höher die Anzahl der Komponenten ist, umso mehr muss die Spezifikation eingeschränkt werden. Die Einhaltung dieser Spezifikation unter allen Randbedingungen wie Temperatur, Versorgungsspannung und Fertigungstoleranzen stellt häufig ein Problem dar.

Es ist bekannt, bei einer großen Anzahl von Systemkomponenten in einer Signalkette regelmäßig eine Retiming-Stufe (Clock-Recovery) einzubauen, um das Signal bezüglich seiner Anforderungen wieder zu regenerieren. Hierbei wird das Signal insbesondere bezüglich Jitter und Duty Cycle aufgefrischt. Solche Retiming-Stufen erfordern jedoch nachteilig einen erheblichen Aufwand an zusätzlichen System-Komponenten.

Aus der veröffentlichten Patentschrift US 2002/0005712 A1 ist ein Treiberschaltkreis für ein Schaltnetzteil bekannt, wobei der Treiberschaltkreis den Duty Cycle eines Gate-Signals für einen Schalttransistor des Schaltnetzteils steuert. Mit Hilfe der Beeinflussung des Duty Cycles wird am Ausgang! des Schaltnetzteils eine stabile Gleichspannung erzeugt, die an eine Last abgebbar ist: Ein Regelkreis regelt die Gleichspannung.

Aus der engiischsprachigen Zusammenfassung der veröffentlichten japanischen Patentschrift JP 59008112 A ist eine Schaltungsanordnung bekannt, mit deren Hilfe ein Duty-Verhältnis,eines EFM Signals automatisch angepasst werden kann. Dabei wird das am Ausgang der Schaltungsanordnung auftretende Signal integriert und mit einer Referenzspannung verglichen, um eine Steuerspannung zu erzeugen, welche den sogenannten "Slice-Level" für einen Schwingungsverlauf-Formungs-Schaltkreis definiert. Die Schaltungsanordnung generiert das EFM Signal ausgangsseitig von einem eingangsseitig anliegenden Hochfrequenzsignal (HF Signal), dem ein Gleichspannungsanteil in Form der Steuerspannung überlagert ist.

Aus dem Patent US 6,504,409 B1 ist ein Controller; der auf eine Eingangsspannung linear antwortet, bekannt, weicher eine kontinuierlich einstellbare Steuerung der Weite eines sich periodisch wiederholenden digitalen Pulses bereitstellt und dadurch eine lineare Spannung zu Duty-Cycle Ratio Transferfunktion erreicht.

Es besteht allgemein ein Bedarf an Schaltungsanordnungen, die in einfacher und effektiver Weise die Regelung eines Parameters eines elektrischen Signals ermöglichen. Insbesondere besteht ein Bedarf an Schaltungsanordnungen zur Regelung des Duty Cycle eines elektrischen Signals.

Zusammenfassung der Erfindung

Die vorliegende Erfindung stellt eine Schaltungsanordnung mit den Merkmalen des beigefügten Anspruchs 1 bereit, die zum Regeln eines Parameters eines elektrischen Signals ausgebildet ist. Sie weist zum einen eine Schaltungskomponente auf, die an einer Ausgangsklemme der Schaltungsanordnung ein elektrisches digitales Ausgangssignal mit einem zu regelnden elektrischen Parameter ausgibt, und zum anderen eine Regeleinrichtung aufweist. Dabei repräsentiert das Ausgangssignal ein digitales Eingangssignal mit einem Duty Cycle. Der zu regelnde Parameter ist der Duty Cycle. Die Regeleinrichtung umfasst einen ersten Integrator, dem das Ausgangssignal der Schaltungskomponente zugeführt wird, und einen zweiten Integrator, dem das Ausgangssignal des ersten Integrators zugeführt wird. Dabei weist der zweite Integrator einen Operationsverstärker mit einem invertierenden Eingang, einem nicht invertierenden Eingang und einem Ausgang auf. Der Ausgang ist über einen Rückkopplungspfad auf den invertierenden Eingang zurückgekoppelt. An dem invertierenden Eingang liegt das Ausgangssignal des ersten Integrators an. An dem nicht invertierenden Eingang liegt ein einen Sollwert darstellendes Referenzsignal an. In dem Rückkopplungspfad ist der Ausgang des Operationsverstärkers über eine Reihenschaltung einer Kapazität mit einem Widerstand auf den invertierenden Eingang zurückgekoppelt. Der Ausgang des ersten Operationsverstärkers stellt ein Ausgangssignal der Regeleinrichtung bereit, das der Schaltungskomponente als Steuergröße zugeführt wird.

Die erfindungsgemäße Schaltungsanordnung beruht auf dem Gedanken, einen zweistufigen Integrator mit einem ersten Integrator und einem dazu in Reihe geschalteten zweiten Integrator als Rückkopplungseinrichtung vorzusehen. Der zweite Integrator wird dabei durch einen Operationsverstärker gebildet. In den Rückkopplungspfad des Operationsverstärkers ist eine Reihenschaltung einer Kapazität mit einem ohmschen Widerstand integriert. Hierdurch wird sichergestellt, dass die der Schaltungskomponente zurückgeführte Steuergröße eine geeignete Phasendrehung aufweist und insbesondere nicht mit einer Phasendrehung von 180° zurückgekoppelt wird. Die Reihenschaltung einer Kapazität und eines Widerstands im Rückkopplungspfad des Operationsverstärkers wirkt dabei als Pol-Nullstellen-Kompensation.

Der zweistufige Integrator bezieht seine Eingangsinformation direkt von der Datenausgangsstufe der Schaltungskomponente. Der zu regelnde Parameter wird über den an dem nicht invertierenden Eingang des Operationsverstärkers anliegenden Sollwert eingestellt. Dabei ist der zu regelnde Parameter bevorzugt der Duty-Cycle des Ausgangssignals. Über den an dem nicht invertierenden Eingang des Operationsverstärkers anliegenden Sollwert kann der Duty Cycle auf exakt 50:50 oder auch einen davon abweichenden Wert eingestellt werden.

Die erfindungsgemäße Lösung stellt eine direkte Regelung des Ausgangssignals über den kompletten relevanten Signalpfad bereit. So wird die Steuergröße der Regeleinrichtung der Schaltungskomponente zugeführt und steuert dort Schaltungsmittel, an denen ein Eingangssignal anliegt. Es erfolgt also eine Regelung vom Eingang bis zum Ausgang. Dies bedeutet, dass unmittelbar auch Ungenauigkeiten im Eingangssignal korrigiert und auch Eingangssignale mit zum Beispiel schlechtem Duty Cycle rekonstruiert werden können. Eventuelle Ungenauigkeiten in nachfolgenden Elementen werden vermieden. Dabei spielt es keine Rolle, ob das Ausgangssignal als Spannungs- oder als Stromsignal vorliegt. Des weiteren wird eine einfache Möglichkeit geschaffen, den Duty Cycle beliebig, d.h. auch auf andere Werte als 50 Prozent einzustellen.

Der erste Integrator ist bevorzugt als Tiefpass ausgebildet. Das an dem nicht invertierenden Eingang des Operationsverstärkers anliegende Referenzsignal wird bevorzugt durch einen resistiven Spannungsteiler bereitgestellt.

Die Schaltungskomponente weist eine Differenzstufe auf, die ein digitales Ausgangssignal erzeugt, dessen Duty Cycle durch die Schaltungsanordnung geregelt wird. Die Differenzstufe weist folgende Komponenten aus: einen ersten Komparator, der mit Eingangssignalen beaufschlagt wird; eine erste Stromquelle zur Steuerung des Stroms durch den ersten Komparator; einen zweiten, zu dem ersten Komparator komplementär aufgebauten Komparator, der mit den gleichen Eingangssignalen beaufschlagt wird; eine zweite Stromquelle zur Steuerung des Stroms durch den zweiten Komparator; eine Einrichtung, die aus den Strömen der beiden Komparatoren ein in seinem Pegel schwankendes Spannungssignal erzeugt; eine Regenerator-Einrichtung, die das schwankende Spannungssignal in ein digitales Ausgangssignal umwandelt und einem Ausgang zuführt; und eine Steuereinrichtung, die in Abhängigkeit von dem Ausgangssignal der Regeleinrichtung zwei Steuersignale erzeugt, von denen eines der ersten Stromquelle und eines der zweiten Stromquelle zugeführt wird. Dabei regelt die erste Stromquelle und die zweite Stromquelle in Abhängigkeit von dem jeweils anliegenden Steuersignal die Ströme durch den ersten Komparator und den zweiten Komparator derart, dass der Duty Cycle des Ausgangssignals der Schaltungskomponente auf einen festgelegten Wert eingestellt wird.

Diese Ausgestaltung beruht auf dem Gedanken, die Stromquellen für die beiden Komparatoren derart zu regeln, dass das Ausgangssignal den gewünschten Duty Cycle aufweist, und das Ausgangssignal selbst dabei als Regelgröße zu verwenden. Über die Ströme durch die beiden Komparatoren können die Umschaltpunkte des betrachteten Signals sehr gut über weite Bereiche verschoben werden. Auch lassen sich die Schnelligkeit der Komparatoren und damit die Anstiegs- bzw. Abfallzeiten in Abhängigkeit von dem zur Verfügung gestellten Strom einstellen. Dabei ist vorgesehen, dass die beiden Stromquellen durch die Steuereinrichtung bevorzugt gegensinnig geregelt werden: in dem Maße, in dem der Strom durch die eine Stromquelle zunimmt, nimmt der Strom durch die andere Stromquelle ab. Es wird gewissermaßen ein konstanter Strom in Abhängigkeit von der Regelung auf die beiden Stromquellen für die beiden Komparatoren aufgeteilt.

Der erste Komparator umfasst bevorzugt einen ersten Eingangs-Differenzverstärker mit zwei Transistoren und der zweite Komparator einen zweiten Eingangs-Differenzverstärker mit zwei Transistoren. Dabei weist der erste Eingangs-Differenzverstärker bevorzugt zwei n-Kanal FET Transistoren auf und ist die erste Stromquelle zwischen Masse und den Source-Anschlüssen der Transistoren des ersten Eingangs-Differenzverstärkers angeordnet. Der zweite Eingangs-Differenzverstärker weist bevorzugt zwei p-Kanal FET Transistoren auf, wobei die zweite Stromquelle zwischen einer Betriebsspannung und den Source-Anschlüssen der Transistoren des zweiten Eingangs-Differenzverstärkers angeordnet ist.

In einer weiteren bevorzugten Ausgestaltung ist die Einrichtung, die aus den Strömen der beiden Eingangs-Differenzverstärker ein in seinem Pegel schwankendes Spannungssignal erzeugt, durch zwei Stromspiegelschaltungen gebildet, die jeweils einen Stromspiegel aus einem ersten Stromspiegel-Tansistor und einem zweiten Stromspiegel-Transistor aufweisen. Dabei sind ein Transistor des einen Stromspiegels und ein Transistor des anderen Stromspiegels miteinander verbunden. Das in seinen Pegel schwankende Spannungssignal wird zwischen diesen beiden Transistoren abgegriffen.

Die Steuereinrichtung der Differenzstufe weist bevorzugt zwei stromführende Arme auf, wobei der Strom durch den einen Arm durch ein Referenzsignal und der Strom durch den anderen Arm durch die Steuergröße der Regeleinrichtung festgelegt ist, und wobei in Abhängigkeit von dem Stromfluss durch den jeweiligen Arm der ersten Stromquelle und der zweiten Stromquelle jeweils ein Steuersignal zugeführt wird. Das Steuersignal ist insbesondere jeweils eine Steuerspannung, die den Strom durch die jeweilige Komparator-Stromquelle einstellt.

In einer bevorzugten Ausgestaltung weist jeder stromführende Arm der Steuereinrichtung einen n-Kanal FET Transistor und einen p-Kanal FET Transistor auf, die in Reihe geschaltet sind. Einer der Transistoren jeden Armes ist bevorzugt über mindestens einen Stromspiegel mit einer der Stromquellen der Komparatoren gekoppelt ist. Auf diese Weise wird an der jeweiligen Stromquelle ein Steuersignal bereitgestellt.

Die Schaltungskomponente weist bevorzugt zusätzlich einen der Differenzstufe nachgeschalteten Ausgangsverstärker auf, dessen Ausgangssignal dem ersten Integrator der Regeleinrichtung zugeführt wird.

Kurze Beschreibung der Zeichnungen

Die Erfindung wird nachfolgend unter Bezugnahme auf die Figuren anhand eines Ausführungsbeispieles näher erläutert.

Es zeigen:

Figur 1    einen Regelkreis zur Regelung des Duty Cycle eines elektrischen Signals mit einer Differenzstufe und einem als Regeleinrichtung dienenden zweistufigen Intergrator und

Figur 2    ein Ausführungsbeispiel der Differenzstufe der Figur 1.

Beschreibung mehrerer bevorzugter Ausführungsbeispiele

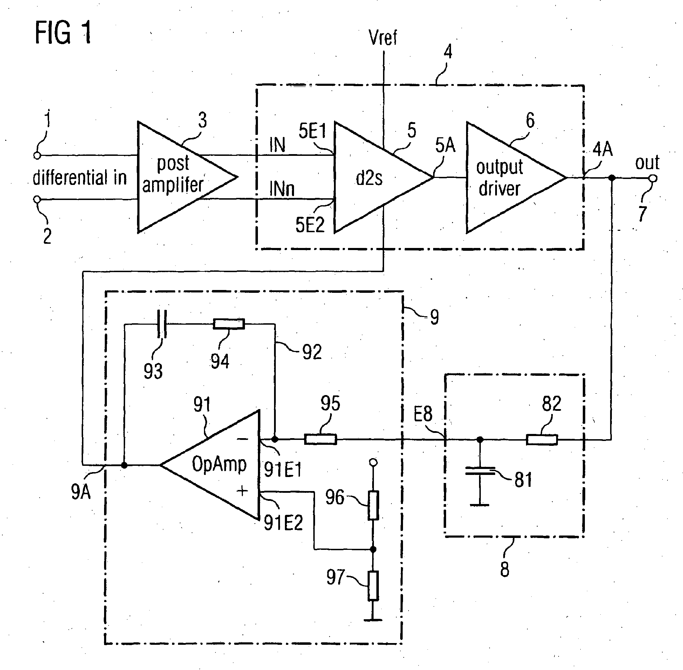

Die Figur 1 zeigt eine Schaltungsanordnung mit einem Vorverstärker 3, einer Differenzstufe 5 und einem Ausgangstreiber 6. Die Differenzstufe 5 weist zwei Eingänge 5E1, 5E2 und einen Ausgang 5A auf. An dem Vorverstärker 3 liegt an zwei Eingangsklemmen 1, 2 ein differenziales Eingangssignal vor. Das differenzielle Ausgangssignal IN, INn des Vorverstärkers 3 wird den Eingängen 5E1, 5E2 der Differenzstufe 5 zugeführt. Die Differenzstufe 5 führt eine "differential-to-single" Umsetzung durch, d.h. das differenzielle Eingangssignal IN, INn wird in ein single-ended Signal umgewandelt. Gleichzeitig erfolgt dabei eine Signalregeneration. Am Ausgang 5A der Differenzstufe 5 liegt ein digitales Ausgangssignal vor, das dem Ausgangstreiber 6 zugeführt wird. Das Ausgangssignal des Ausgangstreibers 6 wird an einer Ausgangsklemme 7 bereitgestellt.

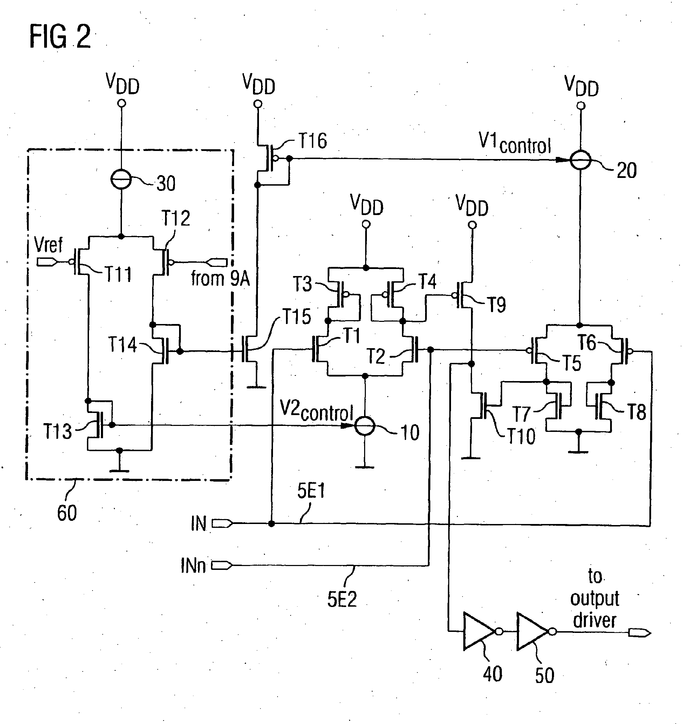

Das an den Eingangsklemmen 1, 2 anliegende differentielle Eingangssignal bzw. das den beiden Eingängen 5E1, 5E2 der Differenzstufe 5 zugeführte Signal besteht aus einer Abfolge von High- und Low-Spannungssignalen, wobei das Eingangssignal möglicherweise eine schlechte Qualität aufweist und insbesondere nicht einen gewünschten Duty Cycle besitzt. Durch eine Steuerung der Stromquellen zweier komplementär aufgebauter Komparatoren der Differenzstufe 5 werden die ansteigenden bzw. abfallenden Flanken des Eingangssignals derart beschleunigt bzw. verzögert, dass sich mittels eines nachgeschalteten Regenerators über die zeitliche Verschiebung des Umschaltepunktes die Pulslänge einstellen lässt. Im Ausgang 5A der Differenzstufe liegt dann ein regeneriertes, digitales Nutzsignal mit einem gewünschten Duty Cycle vor. Dies wird im einzelnen anhand der Figur 2 beschrieben.

Zur Einstellung des Duty Cycles erfolgt eine Regelung. Die zu regelnde Größe ist dabei der Duty Cycle des elektrischen Signals am Ausgang 7 der Schaltung. Die Differenzstufe 5 und der Ausgangstreiber 6 können dabei als Stellglied 4 eines Regelkreises aufgefasst werden, an dessen Ausgang 4A ein Ist-Wert bereitgestellt wird. Eine Regeleinrichtung, die den Ist-Wert erfasst, mit einem Sollwert vergleicht und unter Berücksichtigung der Differenz zwischen Ist-Wert und Soll-Wert eine Steuergröße für das Stellglied 4 bereitstellt, wird durch zwei hintereinander angeordnete Integratoren 8, 9 bereitgestellt. Das an einem Ausgang 9A des zweiten Integrators 9 ausgegebene Ausgangssignal wird als Steuergröße der Differenzstufe 5 zugeführt.

Der erste Integrator 8 wird durch einen Tiefpassfilter gebildet, der aus einer Kapazität 81 und einem ohmschen Widerstand 82 besteht. Der zweite Integrator wird durch einen Operationsverstärker 91 gebildet. Der Operationsverstärker 91 weist einen invertierenden Eingang 91E1 und einen nicht invertierenden Eingang 91E2 auf. Sein Ausgang ist über einen Rückkopplungspfad 92 mit dem invertierenden Eingang 91E1 verbunden. Der Rückkopplungspfad weist eine Reihenschaltung einer Kapazität 93 mit einem ohmschen Widerstand 94 auf.

An dem nicht invertierenden Eingang 91E2 liegt ein Referenzsignal an, das durch einen resistiven Spannungsteiler mit zwei Widerständen 96, 97 bereitgestellt wird. An dem invertierenden Eingang 91E1 liegt das Ausgangssignal des ersten Integrators 8 an, das dem nicht invertierenden Eingang 91E1 über einen weiteren ohmschen Widerstand 95 zugeführt wird.

Die Funktionsweise der Regeleinrichtung 8, 9 ist wie folgt:

Im Ausgang 7 liegt ein digitales Signal vor, das zwischen der maximalen Betriebsspannung VDD und der Massespannung hin und her schwankt. Das digitale Ausgangssignal weist einen bestimmten Duty Cycle auf. Dieser Duty Cycle liegt bevorzugt bei 50 % und die zu erfolgende Regelung soll einen Duty Cycle von 50 % einstellen. Alternativ kann auch ein anderer Wert eingestellt werden.

Durch den ersten Integrator 8 wird das Ausgangssignal integriert, wobei es um einen Mittelwert von VDD/2 mit dem Signaltakt schwankt. Das Ausgangssignal, das am Ausgang E8 des ersten Integrators 8 bereitgestellt wird, ist die über der Kapazität 81 anliegende Spannung. Der erste Integrator stellt eine starke Dämpfung des am Ausgang 7 der Schaltung anliegenden Signals bereit.

Dieses stark gedämpfte Signal wird nun dem zweiten Integrator 9 zugeführt und erfährt dort eine weitere Integration. Am Ausgang 9A des zweiten Integrators liegt ein noch stärker gedämpftes Signal vor, das nur noch geringfügig im Signaltakt schwankt. Idealerweise wäre das Ausgangssignal konstant.

Das Ausgangssignal des ersten Integrators 8 wird über den Widerstand 95 dem invertierenden Eingang 91E1 Operationsverstärker zugeführt. An dem nicht invertierenden Eingang 91E2 wird über den resistiven Spannungsteiler 96, 97 ein Referenzsignal bereitgestellt. Bei einem einzustellenden Duty Cycle von 50 % liegt dieser Referenzwert dabei bei VDD/2, also der halben Betriebsspannung. Der Operationsverstärker 91 vergleicht die an den beiden Eingängen 91E1, 91E2 anliegenden Signale und versucht, die Differenz auf Null zu regeln. Es wird also am Ausgang 9A ein Spannungssignal bereitgestellt, das eine Regelung dahingehend bewirkt, dass das am invertierenden Eingang 91E anliegende Signal die gleiche Größe besitzt wie das nicht invertierenden Eingang 91E2 anliegende Referenzsignal. Das am Ausgang 9A anliegende Spannungssignal stellt die Steuergröße der Regeleinrichtung für das Stellglied 4 dar.

Es ist nun weiter folgendes zu beachten:

Die einzelnen Elemente eines Regelkreises weisen ein bestimmtes Übertragungsverhalten auf, das durch die Übertragungsfunktion und die Phasendrehung definiert wird. Diese Größen sind in Abhängigkeit von der Frequenz üblicherweise in einem sogenannten Bode-Diagramm dargestellt, das dem Fachmann bekannt ist. Die von der Regeleinrichtung 8, 9 bereitgestellte Steuergröße muss derart sein, dass sie der Abweichung zwischen Ist-Wert und Soll-Wert (wobei der Soll-Wert durch den Spannungsteiler 96, 97 bereitgestellt wird) entgegenwirkt. Die Elemente des Regelkreises können die Steuergröße jedoch soweit dynamisch verzögern, dass eine Phasendrehung vorliegt, die die Abweichung weiter vergrößert, anstatt ihr entgegenzuwirken. Es kommt dann zum Schwingen des ganzen Kreises. Um dies vorliegend zu verhindern, darf die am Ausgang 9A ausgegebene Steuergröße gegenüber dem Eingangssignal der Differenzstufe 5 keine Phasendrehung von 180° aufweisen. Vielmehr sollte die Phasendrehung bei maximal 150° liegen. Ein üblicher Integrator kann die Phase jedoch um jeweils -90° drehen, so dass zwei übliche Integratoren eine Phasendrehung von maximal -180° bzw. 180° erreichen können. Diese Phasendrehung soll aber gerade verhindert werden.

Um dies zu verhindern, ist in dem Rückkopplungspfad 92 des Operationsverstärkers 91 der bei Integratoren üblichen Kapazität 93 ein Widerstand 94 in Reihe zugeschaltet. Hierdurch wird eine zusätzliche Phasendrehung bereitgestellt, die die Gesamtphasendrehung der beiden Integratoren 8, 9 reduziert und verhindert, dass sie insgesamt bei 180° liegt.

Dabei ist von Bedeutung, dass der Operationsverstärker 91 trotz Hinzufügen des Widerstands 94 weiterhin als Verstärker arbeitet. Lediglich hinsichtlich seiner Phase liegt ein Unterschied gegenüber herkömmlichen Integratoren vor, bei denen der Rückkopplungspfad lediglich eine Kapazität aufweist.

Es liegt vorliegend ein Integrator mit Pol-Nullstellen-Kompensation (lag-lead compensation) vor. Durch die im Rückkopplungspfad 92 eingebaute Reihenschaltung der Kapazität 83 mit dem Widerstand 94 wird eine Polstelle kompensiert.

Dies wird wie folgt weiter erläutert:

Die Übertragungsfunktion G(s) des zweifachen Integrators 8, 9 ist gegeben durch das Verhältnis der Ausgangsspannung an dem Knoten 7 zur Eingangsspannung an dem Knoten 9A. Es gilt folgende Formel:

$$G(s) = \frac{1 + s \times R(94) \times C(93)}{s \times C(93) \times R(95) \times \left\{ \dfrac{R(82)}{R(95)} + s \times C(81) \times R(82) + 1 \right\}}$$

Dabei gibt die Zahl in runden Klammern jeweils das entsprechende Bezugszeichen der Figur 1 an. R(94) ist beispielsweise der Widerstandswert des Widerstands 94. "s" steht für $j\omega$, wobei $\omega$ gleich der Kreisfrequenz ist.

Die erste Polstelle (= Nullstelle im Nenner) liegt bei s=0 und kann nicht bekämpft werden, d.h. es liegt eine Phasendrehung von 90° schon ab kleinsten Frequenzen vor.

Durch Einfügung des Widerstands R(94) entsteht im Zähler ein Term, der Null werden kann (Nullstelle). Im Nenner ist durch den Term in den geschweiften Klammern eine zweite Polstelle gegeben (neben der ersten bei s=0).

Wenn sich der Term im Zähler und der Term in geschweiften Klammern im Nenner gegenseitig kompensieren, kann man sie kürzen, und es bleibt rechnerisch nur ein Pol bei s=0 übrig. Es liegt eine Pol-Nullstellen-Kompensation vor (lag-lead compensation). Die Pol-Nullstellen-Kompensation wird erreicht durch die Einfügung des Widerstands 94 in den Rückkoppelpfad des Operationsverstärkers 91.

Die Figur 2 zeigt die Differenzstufe 5. Sie besteht aus einem im folgenden als Stromwaage bezeichneten Schaltungsteil 60 sowie zwei Komparatoren, die jeweils durch eine gesteuerte Stromquelle 10, 20 mit Strom versorgt werden.

Zunächst wird auf den Aufbau der beiden Komparatoren sowie die sich daran anschließenden Schaltungsteile eingegangen.

Die beiden Komparatoren sind jeweils durch zwei Eingangs-Differenzverstärkern mit jeweils zwei Transistoren T1, T2 bzw. T5, T6 gebildet. Bei den Transistoren T1, T2 handelt es sich um N-Kanal FET-(Feldeffekttransistor) Transistoren, bei den Transistoren T5, T6 um P-Kanal FET-Transistoren. Der Source-Anschluss der beiden Transistoren T1, T2 ist zusammengeschaltet und mit einer über eine Spannung $V2_{CONTROL}$ regelbaren Stromquelle 10 verbunden, deren anderes Ende mit Masse verbunden ist. Bei der regelbaren Stromquelle handelt es sich beispielsweise um einen FET-Transistor, wobei über die Gate-Spannung $V2_{CONTROL}$ der Strom der Stromquelle und damit durch den Differenzverstärker einstellbar ist.

In entsprechender Weise sind die Source-Anschlüsse der Transistoren T5, T6 des zweiten Eingangs-Differenzverstärkers über eine Spannung $V1_{CONTROL}$ regelbare Stromquelle 20 mit der Betriebsspannung $V_{DD}$ verbunden.

Es sei zunächst der erste Eingangs-Differenzverstärker betrachtet. In Reihe mit dem einen Transistor T1 des Differenzverstärkers ist ein P-Kanal FET Transistor T3 geschaltet, der eine aktive Last bereitstellt. Ebenso ist in Reihe mit dem anderen Transistor T2 des Eingangsdifferenzverstärkers ein P-Kanal FET Transistor T4 geschaltet, der ebenfalls eine aktive Last bereitstellt. Die Source-Anschlüsse der Transistoren T3, T4 sind mit der Betriebsspannung $V_{DD}$ und die Drain-Anschlüsse der Transistoren T3, T4 mit den Drain-Anschlüssen der Transistoren T1, T2 verbunden.

Des weiteren wird mittels eines weiteren Transistors T9 ein Stromspiegel bereitgestellt. Der Transistor T9 ist ein P-Kanal FET-Transistor, dessen Source-Anschluss mit der positiven Betriebsspannung verbunden ist. Der Gate-Anschluss des Transistors T9 ist mit dem Gate-Anschluss des Transistors T4 verbunden. Gleichzeitig ist der Gate-Anschluss des Transistors T4 mit dem Drain-Anschluss des Transistors T2 verbunden. Es liegt eine an sich bekannte Stromspiegelschaltung vor.

Die Funktion des Stromspiegels ist wie folgt: Der durch den Transistor T2 fließende Strom stellt einen Referenzstrom des Stromspiegels dar, der durch den Transistor T4 fließt. Der Stromspiegel erzeugt nun einen Steuerstrom, der in einem bestimmten Verhältnis zum Referenzstrom steht, und der durch den Transistor T9 fließt.

Ein spiegelbildlicher Aufbau einer Stromspiegelschaltung ist bei dem zweiten Eingangs-Differenzverstärker mit den Transistoren T5, T6, T7, T8 und T10 gebildet. Bei den Transistoren T7, T8 und T10 handelt es sich jeweils um N-Kanal FET-Transistoren. Der Drain-Anschluss des Transistors T10 ist mit dem Drain-Anschluss des Transistors T9 verbunden.

Über zwei Eingangsklemmen 1, 2 wird den beiden Eingangs-Differenzverstärkern ein Eingangssignal zugeführt, das aus einer Abfolge von High- und Low-Spannungssignalen besteht, wobei das Eingangssignal möglicherweise eine schlechte Qualität aufweist und insbesondere nicht einen gewünschten Duty Cycle besitzt. Die beiden Eingangs-Differenzstufen werden durch das Eingangssignal derart gesteuert, dass bei einem High-Signal einer der Transistoren T2, T5 leitet, während der andere nicht leitet und bei einem Low-Signal der andere der Transistoren T5, T2 leitet, während der andere Transistor nicht leitet. Beispielsweise fließt bei einem High-Signal ein Strom durch die Transistoren T2, T4 und damit auch durch den einen Transistor T9 der Spiegelschaltung. Zur gleichen Zeit sperrt der Transistor T5 des anderen Eingangs-Differenzverstärkers.

Bei Vorliegen eines Low-Signals sperrt der Transistor T2 des ersten Eingangs-Differenzverstärkers, während der Transistor T5 des zweiten Eingangs-Differenzverstärkers leitet, so dass ein Strom durch die Transistoren T5, T7 und damit auch durch den Transistor T10 der Spiegelschaltung fließt.

Zwischen den Transistoren T9 und T10 wird eine Spannung abgegriffen. Diese Spannung schwankt zwischen einem Low-Wert und einem High-Wert entsprechend den mittels der Stromquellen 10, 20 bereitgestellten Ströme durch die jeweiligen Eingangs-Differenzverstärker, die die Ströme durch die Spiegelschaltungen bzw. die Transistoren T9, T10 bestimmen. Wenn der Transistor T9 leitet, sperrt der Transistor T10 und umgekehrt, so dass abwechselnd eine Spannung nahe oder gleich $V_{DD}$ und nahe oder gleich der Masse-Spannung zwischen den beiden Transistoren T9, T10 abgegriffen wird.

Das abgegriffene Spannungssignal wird einer digitalen Regenerator-Einrichtung zugeführt, die vorliegend aus zwei hintereinander geschalteten Invertern 40, 50 besteht. Die Regenerator Einrichtung wandelt das abgegriffene Spannungssignal in ein digitales Ausgangssignal um und führt dieses dem Ausgang der Differenzstufe zu. Jeder Inverter weist dabei einen Komparator auf, der das Eingangssignal mit einer Schaltschwelle vergleicht und ein digitales Ausgangssignal ausgibt. Das digitale Signal erfüllt anders als das zwischen den Transistoren T9, T10 abgegriffene Signal bestimmte Anforderungen an die Signalqualität, insbesondere an die Konstanz der Signalamplitude, Flankensteilheit und Jitter. Die Regenerator-Einrichtung 40, 50 kann grundsätzlich mit oder ohne Signalinvertierung vorgesehen sein.

Es wird nun auf den Aufbau der als Stromwaage bezeichneten Steuereinrichtung 60 eingegangen, über die die Stromquellen 10, 20 der beiden Komparatoren mit den Steuersignalen V1$_{control}$, V2$_{control}$ beaufschlagt wird.

Die Stromwaage 60 weist eine mit der Betriebsspannung verbundene Stromquelle 30 sowie zwei Stromarme mit insgesamt vier Transistoren T11, T12, T13, T14 auf. Die Transistoren T11, T13 des einen Arms sind in Reihe geschaltet und werden durch einen N-Kanal FET-Transistor T13 und einen P-Kanal FET-Transistor T11 gebildet. Des weiteren sind in dem anderen Arm die Transistoren T12, T14 in Reihe geschaltet, wobei der eine Transistor T14 durch einen N-Kanal FET-Transistor und der Transistor T12 durch einen P-Kanal FET-Transistor gebildet ist. Die Source-Anschlüsse der Transistoren T13, T14 sind zusammengeschaltet und mit Masse verbunden. Ebenso sind die Source-Anschlüsse der P-Kanal-Transistoren T11, T12 zusammengeschaltet und mit der Stromquelle 30 verbunden.

Der Transistor T13 des einen Arms der Stromwaage 60 bildet zusammen mit der Stromquelle 10 des einen Komparators eine Spiegelschaltung. Über den Strom durch den Transistor T13 wird somit auch der Strom durch die Stromquelle 10 eingestellt.

Der Transistor T14 des anderen Arms der Stromwaage 60 bildet mit einem Transistor T15 eine Spiegelschaltung, dieser mit einem weiteren Transistor T16 ebenfalls eine Spiegelschaltung und der Transistor T16 bildet eine Spiegelschaltung mit der Stromquelle 20 des weiteren Komparators. Durch die Stromspiegel stellt der Strom durch den Transistor T14 den Strom durch die Stromquelle 20 ein.

Am Gate-Anschluss des Transistors T11 liegt eine konstante Referenzspannung V$_{REF}$ an. In der Gate-Spannung des Transistors T12 liegt die Steuergröße an, die am Ausgang 9A der Regeleinrichtung 8, 9 bereitgestellt wird.

Im Idealfall, wenn der Duty Cycle auf 50% ausgeregelt ist und der Spannungsteiler 96, 97 am nicht invertierenden Eingang 91E2 des Operationsverstärkers 91 den Wert VDD/2 bereitstellt, sind die Spannung V$_{REF}$ und die Ausgangsspannung der Regeleinrichtung 8, 9 bevorzugt gleich. Bei einem ausgeregelten Signal liegen somit die gleichen Spannungen an den Gate-Anschlüssen der Transistoren T11, T12 vor, so dass durch beide Arme der Stromwaage gleichviel Strom fließt und dementsprechend die Stromquellen 10, 20 der Komparatoren in gleicher Weise Strom für die Komparatoren bereitstellen. In Abhängigkeit von der Auslegung der Transistoren kann grundsätzlich jedoch auch eine unterschiedliche Spannung an den Transistoren T11, T12 anliegen.

Nun sei angenommen, dass der Duty Cycle nicht bei den gewünschten 50% liegen. Beispielsweise liegt das An-/Aus-Verhältnis bzw. das EINS/NULL-Verhältnis bei 60%. Dies führt zunächst dazu, dass das Signal E8 am Ausgang des ersten Integrators 8 ansteigt, d.h. der Mittelwert, um den das Ausgangssignal pendelt, liegt höher. Dieses höhere Signal, dessen Mittelwert also größer als VDD/2 ist, wird dem invertierenden Eingang 91E1 des Operationsverstärkers zugeführt. Es liegt nun eine Differenz zu dem Referenzsignal am Eingang 91E2 vor, das bei VDD/2 liegt. Dementsprechend wird ein Steuersignal am Ausgang 9A des zweiten Integrators ausgegeben, das versucht, diese Differenz auf Null zu regeln. Das geänderte Ausgangssignal des zweiten Integrators 9A führt dazu, dass die Gate-Spannung des Transistors T12 sinkt. Hierdurch wird der Strom in dem Arm mit dem Transistoren T12, T14 erhöht. Dementsprechend sinkt der Strom in dem Arm mit den Transistoren T11, T13. Über die Stromspiegel führt dies dazu, dass die den Stromquellen 10, 20 der Komparatoren zugeführten Steuerspannungen sich ebenfalls ändern. Damit wird der Strom durch den einen Komparator erhöht, während der Strom durch den anderen Komparator reduziert wird. Dies führt aber zu einem Beschleunigen der ansteigenden und abfallenden Flanken des Signals des einen Komparators und einem Verzögern der ansteigenden und abfallenden Flanken des Signals des anderen Komparators.

So lassen sich über die Ströme die Schnelligkeit der Eingangs-Differenzstufen und damit auch die Anstiegs- bzw. Abfallzeiten am Ausgang der Differenzstufe einstellen. Beispielsweise erhöht sich bei einem vergrößerten Strom an der Stromquelle 10 des ersten Eingangs-Differenzverstärkers die Schnelligkeit des ersten Eingangs-Differenzverstärkers, während bei der anderen Stromquelle 20 und dem anderen Eingangs-Differenzverstärker ein umgekehrtes Verhalten vorliegt. Die Regelung führt dazu, dass der Duty Cylce auf einen Wert von 50 Prozent eingestellt wird.

Über die Rückkopplung erfolgt eine Regelung so lange, bis der Duty Cycle auf den gewünschten Wert von 50% eingestellt ist.

Es wird im übrigen noch auf Folgendes hingewiesen.

Grundlage für die Funktion der Schaltungsanordnung ist ein Spannungseingangssignal. Bei Nutzen eines Stromeingangssignals ist daher zusätzlich ein StromSpannungswandler am Eingang der Schaltungsanordnung zu verwenden. Das Eingangssignal kann sowohl single-ended als auch differentiell sein. Bei einer differentiellen Ansteuerung liegen an den beiden Eingangsklemmen 1, 2 zueinander invertierte Eingangssignale an. Bei einer einphasigen (single-ended) Ansteuerung liegt ein Datensignal nur an einer Eingangsklemme an. Für diesen Fall muss der anderen Eingangsklemme eine entsprechende Referenzspannung zugeführt werden.

Die hier beschriebene Schaltungsvorrichtung ist bevorzugt in CMOS-Technologie ausgeführt. In äquivalenter Weise lassen sich jedoch auch entsprechende Schaltungen in BipolarTechnologie und in BiCMOS-Technologie ausführen.

Die Erfindung beschränkt sich in ihrer Ausgestaltung nicht auf die vorstehend dargestellten Ausführungsbeispiele. Der Fachmann erkennt, dass zahlreiche alternative Ausführungsvarianten existieren, die trotz ihrer Abweichung von dem beschriebenen Ausführungsbeispiel nur durch den Bereich der nachfolgenden Ansprüche begrenzt werden.

**Patentansprüche**

1. Schaltungsanordnung zur Regelung eines Parameters eines elektrischen Signals, aufweisend:

   eine Schaltungskomponente (4), die an einer Ausgangsklemme (7) der Schaltungsanordnung ein elektrisches digitales Ausgangssignal mit einem zu regelnden elektrischen Parameter ausgibt, wobei das Ausgangssignal ein differentielles digitales Eingangssignal mit einem Duty Cycle repräsentiert und der zu regelnde Parameter der Duty Cycle des Ausgangssignals
   eine Regeleinrichtung (8, 9) mit
   einem ersten Integrator (8), dem das Ausgangssignal der Schaltungskomponente zugeführt wird, und der ein Ausgangssignal erzeugt,
   einem zweiten Integrator (9), dem das Ausgangssignal des ersten Integrators zugeführt wird, wobei der zweite Integrator (9) einen Operationsverstärker (91) mit einem invertierenden Eingang (91E1), einem nicht invertierenden Eingang (91E2) und
   einem Ausgang aufweist und der Ausgang über einen Rückkopplungspfad (92) auf den invertierenden (91E1) Eingang zurückgekoppelt ist,
   an dem invertierenden Eingang (91E1) das Ausgangssignal des ersten Integrators (8) anliegt,
   an dem nicht invertierenden Eingang (91E2) ein einen Sollwert darstellendes Referenzsignal anliegt,
   in dem Rückkopplungspfad (92) der Ausgang des Operationsverstärkers (91) über eine Reihenschaltung einer Kapazität (93) mit einem Widerstand (94) auf den invertierenden Eingang (91E1) zurückgekoppelt ist, und der Ausgang des Operationsverstärkers (91) ein Ausgangssignal der Regeleinrichtung bereitstellt,
   wobei das Ausgangssignal der Regeleinrichtung (8, 9) der Schaltungskomponente (4) als Steuergröße zugeführt wird, **dadurch gekennzeichnet, dass**
   die erste Schaltungskomponente (4) eine Differenzstufe (5) aufweist, die ein digitales Ausgangssignal erzeugt, dessen Duty Cycle durch die
   Schaltungsanordnung geregelt wird, und wobei
   die Differenzstufe (5)

   einen ersten Komparator, (T1, T2) der mit den differentiellen Eingangssignalen beaufschlagt wird, eine erste Stromquelle (10) zur Steuerung des Stroms durch den ersten Komparator,
   einen zweiten zu dem ersten Komparator komplementär aufgebauten Komparator, (T5, T6) der mit den gleichen differentiellen Eingangssignalen beaufschlagt wird, eine zweite Stromquelle (20) zur Steuerung des Stroms durch den zweiten Komparator,
   eine Einrichtung (T4, T9, T7, T10), die aus den Strömen der beiden Komparatoren ein in seinem Pegel schwankendes Spannungssignal erzeugt,
   eine Regenerator-Einrichtung (40, 50), die das schwankende Spannungssignal in ein digitales Ausgangssignal umwandelt und einem Ausgang zuführt, und
   eine Steuereinrichtung (60), die in Abhängigkeit von dem Ausgangssignal der Regeleinrichtung (8, 9) zwei Steuersignale erzeugt, von denen eines der ersten Stromquelle (10) und eines der zweiten Stromquelle (20) zugeführt wird,

   aufweist.

2. Schaltungsanordnung nach Anspruch 1, wobei der erste Integrator (8) durch einen Tiefpass gebildet ist.

3. Schaltungsanordnung nach Anspruch 1, wobei das an dem nicht invertierenden Eingang (91E2) anliegende Referenzsignal durch einen resistiven Spannungsteiler (96, 96) bereitgestellt ist.

4. Schaltungsanordnung nach Anspruch 1, wobei
   der erste Komparator einen ersten Eingangs-Differenzverstärker mit zwei Transistoren (T1, T2) aufweist,
   die erste Stromquelle (10) in Serie zu den zwei Transistoren (T1, T2) gegen Masse angeordnet ist,
   der zweite Komparator einen zweiten Eingangs-Differenzverstärker mit zwei Transistoren (T5, T6) umfasst,
   die zweite Stromquelle (20) in Serie zu den zwei Transistoren (T5, T6) gegen eine Betriebsspannung angeordnet ist,
   die Einrichtung (T4, T9, T7, T10) durch zwei Stromspiegelschaltungen gebildet ist, die jeweils einen Stromspiegel aus einem ersten Stromspiegel-Transistor und einem zweiten Stromspiegel-Transistor aufweisen, und ein Transistor (T9) des einen Stromspiegels und ein Transistor (T10) des anderen Stromspiegels miteinander verbunden sind, und wobei das in seinem Pegel schwankende Spannungssignal zwischen diesen beiden Transistoren (T9, T10) abgegriffen wird,

das digitale Ausgangssignal bestimmte Anforderungen an die Signalqualität, insbesondere an die Konstanz der Signalamplitude, Flankensteilheit und Jitter erfüllt,

die Steuereinrichtung (60) zwei stromführende Arme aufweist, wobei der Strom durch den einen Arm durch ein Referenzsignal (Vref) und der Strom durch den anderen Arm durch die Steuergröße der Regeleinrichtung (8, 9) festgelegt ist, und wobei in Abhängigkeit von dem Stromfluss durch den jeweiligen Arm der ersten Stromquelle (10) und der zweiten Stromquelle (20) jeweils ein Steuersignal zur Steuerung des Stroms durch den jeweiligen Komparator zugeführt wird, und

wobei die erste Stromquelle (10) und die zweite Stromquelle (20) in Abhängigkeit von dem jeweils anliegenden Steuersignal die Ströme durch den ersten Komparator und den zweiten Komparator derart gegensinnig regeln, dass sich über die Ströme die Schnelligkeit der Eingangs-Differenzstufen und damit auch die Anstiegs- bzw. Abfallzeiten am Ausgang der Differenzstufe einstellen lassen und folglich der Duty Cycle des Ausgangssignals der Schaltungskomponente auf einen festgelegten Wert eingestellt wird.

5. Schaltungsanordnung nach Anspruch 4, wobei der erste Eingangs-Differenzverstärker zwei n-Kanal FET Transistoren (T1, T2) aufweist und die erste Stromquelle (10) zwischen Masse und den Source-Anschlüssen der Transistoren des ersten Eingangs-Differenzverstärkers angeordnet ist.

6. Schaltungsanordnung nach Anspruch 4, wobei der zweite Eingangs-Differenzverstärker zwei p-Kanal FET Transistoren (T5, T6) aufweist und die zweite Stromquelle (20) zwischen einer Betriebsspannung und den Source-Anschlüssen der Transistoren des zweiten Eingangs-Differenzverstärkers angeordnet ist.

7. Schaltungsanordnung nach Anspruch 4, wobei das Steuersignal eine Steuerspannung (Vref) ist.

8. Schaltungsanordnung nach Anspruch 4, wobei jeder stromführende Arm der Steuereinrichtung einen n-Kanal FET Transistor (T13, T14) und einen p-Kanal FET Transistor (T11, T12) aufweist, die in Reihe geschaltet sind.

9. Schaltungsanordnung nach Anspruch 8, wobei einer der Transistoren (T13, T14) jeden Armes über mindestens einen Stromspiegel mit einer der Stromquellen (10, 20) der Komparatoren gekoppelt ist.

10. Schaltungsanordnung nach Anspruch 1, wobei die Schaltungskomponente zusätzlich einen der Differenzstufe (5) nachgeschalteten Ausgangsverstärker (6) aufweist, dessen Ausgangssignal dem ersten Integrator (8) der Regeleinrichtung zugeführt wird.

## Claims

1. Circuit arrangement for regulation of a parameter of an electrical signal, comprising:

a circuit component (4) which outputs an electrical digital output signal with an electrical parameter to be regulated at an output terminal (7) of the circuit arrangement, wherein the output signal represents a differential digital input signal with a duty cycle and the parameter to be regulated is the duty cycle of the output signal, a regulating unit (8, 9) with

a first integrator (8) which is supplied with the output signal of the circuit component and which generates an output signal,
a second integrator (9) which is supplied with the output signal of the first integrator, wherein

the second integrator (9) comprises an operational amplifier (91) with an inverting input (91E1), a non-inverting input (91E2) and an output, and the output is coupled back to the inverting (91E1) input via a feedback path (92), at the inverting input (91E1) the output signal of the first integrator (8) is applied,
at the non-inverting input (91E2) a reference signal representing a desired value is applied,
in the feedback path (92) the output of the operational amplifier (91) is coupled back to the inverting input (91E1) via a capacity (93) and a resistor (94) connected in series, and
the output of the operational amplifier (91) provides an output signal of the regulating unit,
wherein the output signal is supplied to the regulating unit (8, 9) of the circuit component (4) as a control factor,
**characterized in that**
the first circuit component (4) comprises a differential stage (5) which generates a digital output signal, the duty cycle of which is regulated by the circuit arrangement, and wherein

the differential stage (5) comprises
a first comparator (T1, T2) which is supplied with the differential input signals,
a first current source (10) for controlling the current through the first comparator,
a second comparator (T5, T6) constructed complementary to the first comparator, which is supplied with the same differential input signals,
a second current source (20) for controlling the current through the second comparator,
a unit (T4, T9, T7, T10) which generates from the currents of the both comparators a voltage signal fluctuating in its level,
a regenerator unit (40, 50) which converts the fluctuating voltage signal to a digital output signal and supplies it to an output, and
a control unit (60) which in dependency on the output signal of the regulating unit (8, 9) generates two control signals, of which one is supplied to the first current source (10) and one is supplied to the second current source (20).

2.  Circuit arrangement according to claim 1, wherein the first integrator (8) is formed by a low-pass.

3.  Circuit arrangement according to claim 1, wherein the reference signal applied to the non-inverting input (91E2) is provided by a resistive voltage divider (96, 96).

4.  Circuit arrangement according to claim 1, wherein
the first comparator comprises a first input differential amplifier with two transistors (T1, T2),
the first current source (10) is arranged in series to the two transistors (T1, T2) against ground,
the second comparator includes a second input differential amplifier with two transistors (T5, T6),
the second current source (20) is arranged in series to the two transistors (T5, T6) against an operational voltage,
the unit (T4, T9, T7, T10) is formed by two current mirror circuits, which respectively comprise a current mirror from a first current mirror transistor and a second current mirror transistor, and a transistor (T9) of the one current mirror and a transistor (T10) of the other current mirror are connected to each other, and wherein the voltage signal fluctuating in its level is tapped between these both transistors (T9, T10),
the digital output signal meets certain requirements for the signal quality, in particular for the constancy of the signal amplitude, slope steepness and jitter,
the control unit (60) comprises two current conducting arms, wherein the current through the one arm is set by a reference signal (Vref) and the current through the other arm is set by the control factor of the regulating unit (8, 9), and wherein in dependency on the current flow through the respective arm of the first current source (10) and the second current source (20) respectively a control signal for controlling the current is supplied through the respective comparator, and
wherein the first current source (10) and the second current source (20) in dependency on the respectively applied control signal regulate the currents through the first comparator and the second comparator such in an opposite direction that by the currents the velocity of the input differential stages and thereby also the rise time and fall time, respectively, at the output of the differential stage can be adjusted and consequently the duty cycle of the output signal of the circuit component is adjusted to a set value.

5.  Circuit arrangement according to claim 4, wherein the first input differential amplifier comprises two n-channel FET transistors (T1, T2) and the first current source (10) is arranged between ground and the source terminals of the transistors of the first input differential amplifier.

6.  Circuit arrangement according to claim 4, wherein the second input differential amplifier comprises two p-channel FET transistors (T5, T6) and the second current source (20) is arranged between an operational voltage and the sources terminals of the transistors of the second input differential amplifier.

7.  Circuit arrangement according to claim 4, wherein the control signal is a control voltage (Vref).

8.  Circuit arrangement according to claim 4, wherein each current conducting arm of the control unit comprises an n-channel FET transistor (T13, T14) and a p-channel FET transistor, which are connected in series.

9.  Circuit arrangement according to claim 8, wherein one of the transistors (T13, T14) of each arm is coupled via at least one current mirror with one of the current sources (10, 20) of the comparators.

10. Circuit arrangement according to claim 1, wherein the circuit component additionally comprises an output amplifier (6) downstream of the differential stage (5), the output signal of which is supplied to the first integrator (8) of the regulating unit.

**Revendications**

1. Circuit servant à régler un paramètre d'un signal électrique, comprenant :

un composant (4) de circuit, qui émet, à une borne (7) de sortie du circuit, un signal de sortie TOR électrique avec un paramètre électrique à régler, le signal de sortie représentant un signal d'entrée TOR différentiel avec un cycle de service et le paramètre à régler étant le cycle de service du signal de sortie,
un dispositif (8,9) de réglage comportant
un premier intégrateur (8), auquel le signal de sortie du composant de circuit est acheminé et qui produit un signal de sortie,
un deuxième intégrateur (9), auquel le signal de sortie du premier intégrateur est acheminé,
le deuxième intégrateur (9) présentant un amplificateur opérationnel (91) ayant une entrée (91 E1) à inversion, une entrée (91 E2) sans inversion et une sortie, et la sortie étant rétrocouplée à l'entrée (91E1) à inversion via un chemin (92) de rétroaction,
le signal de sortie du premier intégrateur (8) étant appliqué à l'entrée (91E1) à inversion,
un signal de référence représentant une consigne étant appliqué à l'entrée (91 E2) sans inversion,
la sortie de l'amplificateur opérationnel (91) étant rétrocouplée à l'entrée (91E1) à inversion dans le chemin de rétroaction via le branchement d'une capacité (93) en série avec une résistance (94), et
la sortie de l'amplificateur opérationnel (91) fournissant un signal de sortie du dispositif de réglage,
le signal de sortie du dispositif de réglage (8, 9) étant acheminé au composant (4) de circuit en tant que variable de commande,
**caractérisé en ce que** le premier composant (4) de circuit présente un étage différentiel (5),
produisant un signal de sortie TOR, dont le cycle de service est réglé par le circuit, et l'étage différentiel (5) présentant
un premier comparateur (T1, T2), alimenté par les signaux d'entrée différentiels,
une première source (10) de courant servant à commander le courant traversant le premier comparateur,
un deuxième comparateur (T5, T6), réalisé de manière complémentaire au premier comparateur, qui est alimenté avec les mêmes signaux d'entrée différentiels,
une deuxième source (20) de courant servant à commander le courant traversant le deuxième comparateur,
un dispositif (T4, T9, T7, T10) qui produit un signal de tension dont le niveau fluctue, à partir des flux des deux comparateurs,
un dispositif (40, 50) de régénération, qui convertit le signal de tension fluctuant en un signal de sortie TOR et l'achemine à une sortie,
un dispositif (60) de commande, qui produit deux signaux de commande en fonction du signal de sortie du dispositif (8, 9) de réglage, dont l'un est acheminé à la première source (10) de courant et l'autre, à la deuxième source (20) de courant.

2. Circuit selon la revendication 1, dans lequel le premier intégrateur (8) est formé par un filtre passe-bas.

3. Circuit selon la revendication 1, dans lequel le signal de référence appliqué à l'entrée (91 E2) sans inversion est fourni via un diviseur (96, 97) de tension résistif.

4. Circuit selon la revendication 1, dans lequel
le premier comparateur présente un premier amplificateur différentiel d'entrée avec deux transistors (T1, T2),
la première source (10) de courant est montée en série avec les deux transistors (T1, T2) à côté de la masse,
le deuxième comparateur comprend un deuxième amplificateur différentiel d'entrée avec deux transistors (T5, T6),
la deuxième source (20) de courant est montée en série avec les deux transistors (T5, T6) à côté d'une tension de service,
le dispositif (T4, T9, T7, T10) est formé par deux circuits à miroir de courant, comprenant chacun un miroir de courant d'un premier transistor de miroir de courant et d'un deuxième transistor de miroir de courant, un transistor (T9) de l'un des miroirs de courant et un transistor (T10) de l'autre miroir de courant étant reliés l'un à l'autre, et le signal de tension dont le niveau fluctue étant prélevé entre ces deux transistors (T9, T10),
le signal de sortie TOR remplit certains critères de qualité, notamment en ce qui concerne la constance de l'amplitude du signal, la pente des fronts, et la gigue,

le dispositif (60) de commande présente deux branches conductrices de courant, le courant traversant l'une des branches étant déterminé par un signal de référence (Vref) et le courant traversant l'autre branche étant déterminé par la variable de commande du dispositif (8,9) de réglage, et un signal de commande servant à commander le courant traversant le comparateur correspondant étant acheminé respectivement à la première source (10) de courant et à la deuxième source (20) de courant en fonction du courant traversant la branche respective, et la première source (10) de courant et la deuxième source (20) de courant règlent les flux traversant le premier comparateur et le deuxième comparateur en fonction du signal de commande respectivement appliqué en sens inverse de telle sorte que la vitesse des étages différentiels d'entrée et ainsi les temps de montée ou de descente peuvent être réglés via les flux à la sortie de l'étage différentiel et par conséquent le cycle de service du signal de sortie du composant de circuit est réglé sur une valeur déterminée.

5. Circuit selon la revendication 4, dans lequel le premier amplificateur différentiel d'entrée présente deux transistors (T1, T2) à effet de champ à canal n, et dans laquelle la première source (10) de courant est montée entre la masse et les raccords source des transistors du premier amplificateur différentiel d'entrée.

6. Circuit selon la revendication 4, dans lequel le deuxième amplificateur différentiel d'entrée présente deux transistors (T5, T6) à effet de champ à canal p et la deuxième source (20) de courant est montée entre une tension de service et les raccords source des transistors du deuxième amplificateur différentiel d'entrée.

7. Circuit selon la revendication 4, dans lequel le signal de commande est une tension de commande (Vref).

8. Circuit selon la revendication 4, dans lequel chaque branche conductrice de courant du dispositif de commande présente un transistor (T13, T14) à effet de champ à canal n et un transistor (T11, T12) à effet de champ à canal p, montés en série.

9. Circuit selon la revendication 8, dans lequel l'un des transistors (T13, T14) de chaque branche est couplé à l'une des sources (10, 20) de courant des comparateurs via au moins un miroir de courant.

10. Circuit selon la revendication 1, dans lequel le composant de circuit présente en plus un amplificateur (6) de sortie branché en aval de l'étage différentiel (5) et dont le signal de sortie est acheminé au premier intégrateur (8) du dispositif de réglage.

## FIG 1

Vref

4

1

differential in

2

3

post
amplifer

IN    5E1

INn

5E2

5

d2s

5A

6

output
driver

4A

out

7

9

93    94    92

91    95    E8    82

OpAmp    91E1    81    8

9A    91E2    96

97

FIG 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20020005712 A1
- JP 59008112 A
- US 6504409 B1